# EUROPEAN PATENT SPECIFICATION

(11) **EP 4 239 694 B1**
(45) Date of publication and mention of the grant of the patent: **25.09.2024**
(21) Application number: 23152548.6
(22) Date of filing: 19.01.2023
(51) Int. Cl.: H01L 33/00, H01L 33/44, H01L 33/50

(54) **HYBRID LIGHT EMITTING DIODE AND METHOD FOR MANUFACTURING THE SAME**
HYBRID-LEUCHTDIODE UND VERFAHREN ZUR HERSTELLUNG DAVON
DIODE ÉLECTROLUMINESCENTE HYBRIDE ET SON PROCÉDÉ DE FABRICATION

(30) Priority: 26.02.2022 PL 44048022
(43) Date of publication of application: 06.09.2023
(73) Proprietor: Instytut Wysokich Cisnien Polskiej Akademii Nauk, 01-142 Warszawa (PL); Uniwersytet Warszawski, 00-927 Warszawa (PL)
(72) Inventor: SKIERBISZEWSKI, Czeslaw, 05-502 Kamionka (PL); SLAWINSKA, Julia, 04-690 Warszawa (PL); CHLIPALA, Mikolaj, 84-200 Wejherowo (PL); SIEKACZ, Marcin, 03-395 Warszawa (PL); ORESZCZUK, Kacper, 26-720 Zawada Nowa 9 (PL); RODEK, Aleksander, 03-980 Warszawa (PL); KOSSACKI, Piotr, 00-873 Warszawa (PL)
(74) Representative: AOMB Polska Sp. z.o.o.

(56) References cited:
- CN-A- 111 261 764
- US-A1- 2013 026 447
- US-A1- 2019 363 514

## Description

The present invention relates to a hybrid light emitting diode emitting single photons and a method of fabrication of a hybrid light emitting diode emitting single photons.

Sources of single photons, containing a photon emitter in the form of a two-dimensional semiconductor transition metal dichalcogenide (2D TMD) layer excited by laser light, are applied widely in telecommunication for quantum key distribution in secure encrypted connections. Emitters of single photons in the form of a two-dimensional semiconductor layer of tungsten diselenide (WSe₂), which, when excited by an external light with the wavelength of 400-550 nm, can emit single photons with the wavelength of 650-750 nm, are disclosed, among others, in the article by K.F. Mak and J. Shan titled "Photonics and optoelectronics of 2D semiconductor transition metal dichalcogenides" [Nature Photonics, vol. 10, pp. 216-226 (2016)] and in the article by M. Koperski et al. titled "Single photon emitters in exfoliated WSe2 structures" [Nature Nanotechnology. Vol. 10, pp. 503-506 (2015)].

The article by C. Palacios-Berraquero et al. titled "Atomically thin quantum light-emitting diodes" [Nature Communications vol. 7, Art. no.: 12978 (2016)] reveals that it is possible to fabricate an optoelectronic device emitting single photons, which is based only on an electric supply of the TMD layer. However, the fabrication of such device requires a very advanced technology of transferring thin layers of graphene, hBN or TMD. Such a procedure is very sensitive to external conditions, e.g. vibrations.

The existing sources of single photons, which are based on light emission from quantum dots placed in resonant cavities, still require a complicated system that transmits the light of the exciting laser. Examples of such sources are disclosed in the publication by P. Senellart, G. Solomon and A. White titled "High-performance semiconductor quantum-dot-photon sources" [Nat Nanotechnol, 2017.12(11), pp. 1026-1039] and in the publication by A.K. Nowak et al. titled "Deterministic and electrically tunable bright single-photon source" [Nature Communications, 5(1):3240, 2014]. The devices described in these publications are offered on the market by Quandela, and their descriptions can be found on the websites: https://optoecomponents.com/single-photon-source-from-quandela/ and http://quandela.com.

US 2019/363514 A1 discloses a LED device comprising a WSe2 layer as a LED pumped nano cavity laser as a nanocavity laser.

Optoelectronic devices based on gallium nitride and its InAlGaN type alloys, such as light emitting diodes and laser diodes which emit light within the range from ultraviolet to red, have been known for many years. Nitride diodes achieve very high efficiencies and are mass produced as sources of white light and a light source for telecommunication.

Object of the invention is to develop a compact single-photon source that makes use of a nitride light emitting diode as a source of light that excites a photon emitter.

This object is achieved by a hybrid diode according to the invention, characterised in that it contains a photon emitter in the form of a transition metal dichalcogenide (TMD) monolayer and a source of light exciting the emitter, in the form of an epitaxial layer structure of a light emitting diode made of group-III nitrides on a crystalline substrate of gallium nitride. The aforementioned layer structure is composed of, counted from the crystalline substrate, a lower n-type conductivity layer, a tunnel junction, a hole injection layer, an active region, an electron injection layer, and an upper n-type conductivity layer. A photon emitter is placed on the surface of the upper n-type conductivity layer, in a light emission region surrounded by a region of an epitaxial structure that is made electrically inactive by the ion implantation method. The implanted region extends vertically from the upper surface of the electron injection layer to the inside of the lower n-type conductivity layer. The surface area of the light emitting region on the upper surface of the electron injection layer ranges from 7 to 5000 µm² and can be inscribed into a circle with the diameter of at least 3 µm. The active region of the light emitting diode is composed, counted from the crystalline substrate, of a lower barrier layer, a quantum well layer and an upper barrier layer. The lower and upper barrier layers of the active region are made of an undoped InₓGa₁₋ₓN indium gallium nitride alloy, wherein the indium content *x* ranges from 0.01 to 0.08. The quantum well layer is made of an undoped In_{y}Ga_{1-y}N indium gallium nitride alloy, wherein the indium content y ranges from 0.1 to 0.2.

In one of the variants of a hybrid diode according to the invention, a photon emitter is composed of a tungsten diselenide (WSe₂) monolayer, a tungsten disulfide (WS₂) monolayer or a molybdenum disulfide (MoS₂) monolayer.

In another variant of a hybrid diode according to the invention, a tunnel junction is composed, counted from the crystalline substrate, of a first sublayer, a second sublayer, a third sublayer and a fourth sublayer, all made of doped In_{y}Ga_{1-y}N indium gallium nitride alloys. The indium contents y in the first and in the fourth sublayer of the tunnel junction are identical and range from 0.01 to 0.04 and said sublayers are doped with silicon and magnesium, respectively, at the level from 2 × 10¹⁹ cm⁻³ to 5 × 10¹⁹ cm⁻³. The indium contents y in the second and in the third sublayer of the tunnel junction are identical and range from 0.15 to 0.25. The second sublayer of the tunnel junction is silicon- or germanium-doped with the doping level ranging from 50 × 10¹⁹cm⁻³ to 100 × 10¹⁹ cm⁻³, while the third sublayer of the tunnel junction is magnesium-doped with the doping level ranging from 10 × 10¹⁹ cm⁻³ to 50 × 10¹⁹ cm⁻³.

The method according to the invention relates to the fabrication of a hybrid diode, that is, an optoelectronic device containing a photon emitter in the form of a transition metal dichalcogenide (TMD) monolayer and a light source exciting the photon emitter. The invention consists in that first an epitaxial layer structure of a light emitting diode, fulfilling the role of an exciting light source, is fabricated. This structure is fabricated by applying layers of group-III nitrides on a crystalline substrate made of gallium nitride in the process of nitrogen plasma-assisted molecular beam epitaxy (PAMBE) growth. A lower n-type conductivity layer, a tunnel junction, a hole injection layer, an active region and an electron injection layer are deposited successively on the aforementioned crystalline substrate. Subsequently, the layer structure growth process is interrupted and the light emission field on the upper surface of the electron injection layer is limited by surrounding the original light emission field with an epitaxial structure region that is made electrically inactive by the ion implantation method. The layer structure region that is electrically inactive extends vertically from the upper surface of the electron injection layer to the inside of the lower n-type conductivity layer such that the surface area of the limited light emission field ranges from 7 to 5000 µm² and can be inscribed into a circle with the diameter of at least 3 µm. After the aforementioned limitation of the light emission field, the epitaxial growth is ended by applying a subsequent upper n-type conductivity layer. In the next step, a photon emitter is placed on the surface of the upper n-type conductivity layer, in the previously defined light emission field of the light emitting diode. During the fabrication of the active region of said diode, a lower barrier layer, a quantum well layer and an upper barrier layer are applied successively, counted from the crystalline substrate. The lower and upper barrier layers are made of an undoped InₓGa₁₋ₓN indium gallium nitride alloy, wherein the indium content *x* ranges from 0.01 to 0.08, while the quantum well layer is made of an undoped In_{y}Ga_{1-y}N indium gallium nitride alloy, wherein the indium content y ranges from 0.1 to 0.2.

In one of the variants of the method according to the invention, a tungsten diselenide (WSe₂) monolayer, a tungsten disulfide (WS₂) monolayer or a molybdenum disulfide (MoS₂) monolayer is used as a photon emitter.

In another variant of the method according to the invention, the application of a tunnel junction consists in applying successively, counted from the crystalline substrate, a first sublayer, a second sublayer, a third sublayer and a fourth sublayer, which are made of doped In_{y}Ga_{1-y}N indium gallium nitride alloys. The indium contents y in the first and in the fourth sublayer of the tunnel junction are identical and range from 0.01 to 0.04, wherein said sublayers are doped with silicon and magnesium, respectively, with the doping level from 2 × 10¹⁹ cm⁻³ to 5 × 10¹⁹ cm⁻³. The indium contents y in the second and in the third sublayer of said tunnel junction are identical and range from 0.15 to 0.25. The second sublayer of the tunnel junction is doped with silicon or germanium with the doping level ranging from 50 × 10¹⁹ cm⁻³ to 100 × 10¹⁹ cm⁻³, while the third sublayer of the tunnel junction is doped with magnesium with the doping level ranging from 10 × 10¹⁹ cm⁻³ to 50 × 10¹⁹ cm⁻³.

A hybrid diode according to the invention is characterised by a high emission quality because the g₂ correlation coefficient determined for said diode is significantly lower than 0.5. This is an effect of the spatial limitation of the exciting light emission region, which made it possible to limit the impact of the background radiation in the wavelength range corresponding to TMD layer emission. Said diode successfully replaces a traditional single photon emitter. The low operating voltage of such a diode allows harmful heating of the epitaxial structure, which might lead to deterioration of emission quality, to be avoided. It enables an effective conversion of the current into exciting light. It is possible to adjust the size of the exciting emission region in a simple manner by adapting it to the applied size of the photon emitter. The small dimensions of a hybrid diode according to the invention enable its placement in a standard TO5.6 type diode mount, which allows easy integration with the existing electronic circuits. A hybrid diode according to the invention does not require positioning (aligning) the exciting light beam, which essentially limits the impact of vibrations and shocks on the stability of the operation of this device. The small dimensions enable also the application of efficient and economical cooling systems, such as Peltier devices, in order to achieve the required operating temperature. The invention makes it possible to build miniature and portable single photon emission circuits, which significantly extends the area of their possible applications, for example in miniature signal transmitters for quantum key distribution in telecommunication (for example in 5G networks).

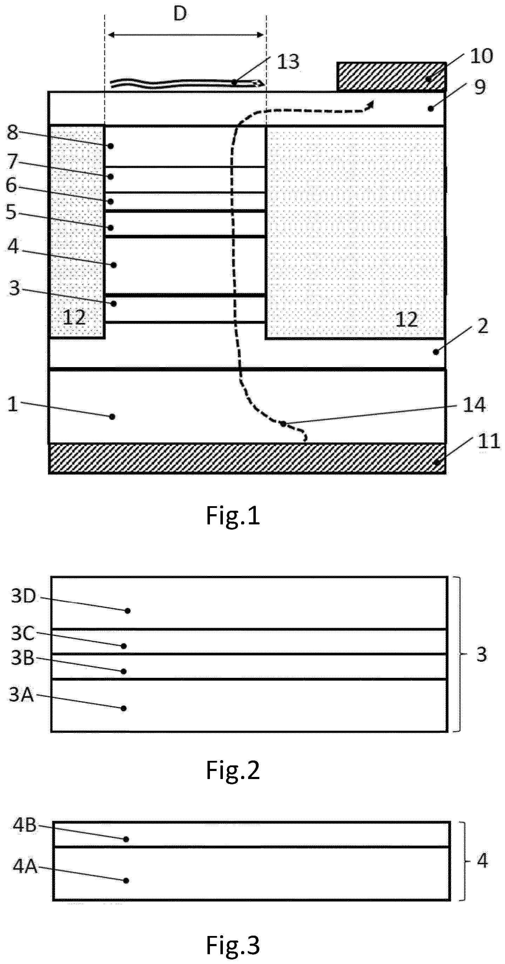

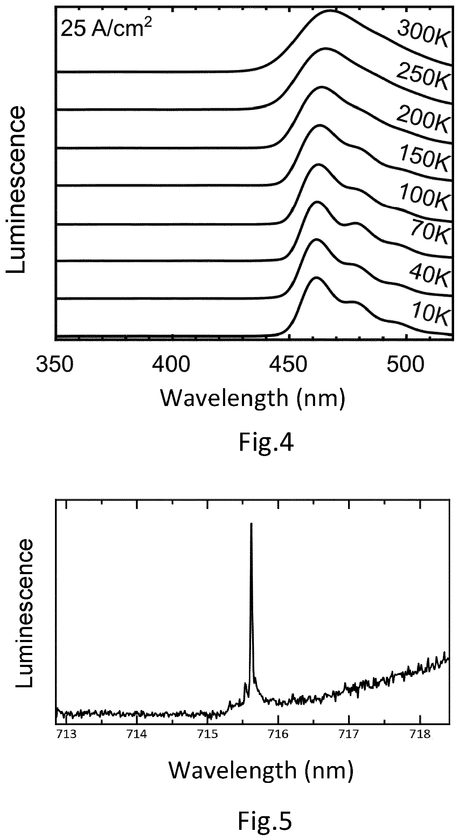

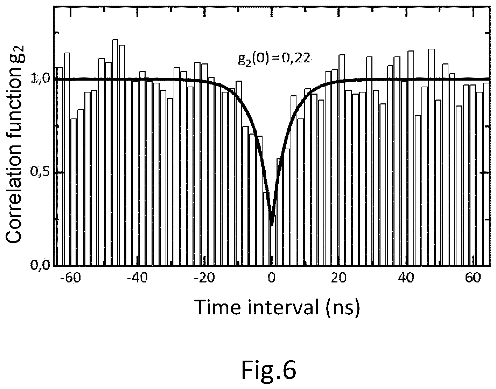

An embodiment of the invention is reflected in a drawing, with Fig.1 presenting schematically a vertical profile of a hybrid diode according to the invention, Fig.2 presenting a tunnel junction structure of the diode from Fig.1, and Fig.3 presenting a hole injection layer structure of the same diode. Fig.4 presents a spectrum of electroluminescence of a source of light exciting the photon emitter from Fig.1 for eight different temperatures ranging from 10 K to 300 K. Fig.5 presents a spectrum of an excited photon emitter from Fig.1 at the temperature of 10 K, while Fig.6 presents a function of the g₂ correlation of the photons emitted by said emitter at the temperature of 10 K.

The present invention is presented in more detail in the embodiment described below. The exciting light source of an embodiment of a hybrid diode according to the invention was fabricated in the process of nitrogen plasma-assisted molecular beam epitaxy (PAMBE) growth. The substrate 1 of gallium nitride with the thickness of 350 µm was baked in a prechamber at the temperature of 150°C for 1.5 hours. Subsequently, the baking was continued in a preparatory chamber at the temperature of 650°C for 30 minutes. The baked sample was transferred to a growth chamber and epitaxial growth was performed in metal-rich conditions. The nitrogen used for the growth was supplied in the form of plasma generated by a power supply unit with the power of 420 W and the nitrogen flow of 2 sccm. At the temperature of 730°C a lower n-type GaN conductivity layer 2, with the thickness of 75 nm and the silicon doping level of 5 × 10¹⁹ cm⁻³, was fabricated. Subsequently, the growth temperature was reduced to 650°C and a tunnel junction 3 with the thickness of 90 nm was fabricated. The tunnel junction 3 was composed of four sublayers: 3A, 3B, 3C and 3D (Fig.2). The first, counted from the substrate 1, sublayer 3A with the thickness of 40 nm was made of a silicon-doped In_{0.02}Ga_{0.98}N alloy, with the doping level of 5 × 10¹⁹cm⁻³. The second sublayer 3B with the thickness of 5 nm was made of a silicon-doped In_{0.21}Ga_{0.79}N alloy, with the doping level of 5 × 10²⁰ cm⁻³. The third sublayer 3C with the thickness of 5 nm was made of a magnesium-doped In_{0.21}Ga_{0.79}N alloy, with the doping level of 5 × 10²⁰ cm⁻³. The fourth sublayer 3D of the tunnel junction 3 had the thickness of 40 nm and was made of a magnesium-doped In_{0.02}Ga_{0.98}N alloy, with the doping level of 5 × 10¹⁹ cm⁻³. Subsequently, the growth temperature was increased to 730°C and a hole injection layer 4 with the thickness of 125 nm was made of magnesium-doped GaN, with the first 100 nm of the thickness (4A) of the layer 4 was doped with magnesium with the doping level of 1 × 10¹⁹cm⁻³, while the successive 25 nm of the thickness (4B) of the layer 4 was doped with magnesium with the doping level of 5 × 10¹⁹ cm⁻³ (Fig.3). Subsequently the temperature was reduced to 650°C and an active region was fabricated, composed of a lower barrier layer 5 with the thickness of 30 nm, made of an undoped In_{0.08}Ga_{0.92}N alloy, of a quantum well layer 6 with the thickness of 15 nm, made of an undoped In_{0.17}Ga_{0.83}N alloy, and of an upper barrier layer 7 with the thickness of 30 nm made of an undoped In_{0.08}Ga_{0.92}N alloy. Subsequently the temperature was increased and an electron injection layer 8 with the thickness of 150 nm was fabricated of GaN. At the next stage the sample was removed from the molecular beam epitaxy (MBE) machine and subjected to the photolithography process for the purpose of creating target regions of emission of light that excites the emission of single photons. After masking the regions with the diameter D (Fig.1), with the size ranging from 3 to 80 µm, with a photoresist with the thickness of 2 µm on the upper surface of the electron injection layer 8, the sample was subjected to the process of He⁺ implantation with the energy of 100 keV and the dose of 1.5 × 10¹⁴ cm⁻³. It is important that the implantation depth 12 is so deep enough for ions to penetrate the strongly doped tunnel junction 3. After removing the photoresist away, the sample was placed in the prechamber of the MBE machine at the temperature of 150°C for 1.5 hours. Subsequently, the baking was continued in a preparatory chamber at the temperature of 650°C for 30 minutes. The baked sample was transferred to a growth chamber and epitaxial growth of the upper n-type conductivity layer 9 with the thickness of 200 nm, made of silicon-doped GaN with the doping level of 8 × 10¹⁸ cm⁻³, was performed in metal-rich conditions. After removing from the MBE machine again, metallisation 10 (upper contact) with the thickness of 25 nm/75 nm was made on the gallium side outside the light emitting region and metallisation 11 (lower contact) was made on the whole nitrogen surface of the substrate 1. Subsequently, devices with contacts 10 and 11 with the dimensions of 350 µm x 350 µm were separated. The surface areas of the light emitting regions, limited by the regions 12, which were made electrically inactive as a result of ion implantation, ranged from 7 to 5000 µm², arising from the diameters D of photoresist mask, with which the layer structure was shielded from the impact of the aforementioned ion implantation. In the case of a different shape of the mask that shields LED structure from the impact of ion implantation that results in electric inactivity, it is important that the target light emitting region can be inscribed into a circle with the diameter D of at least 3 µm. Subsequently, a photon emitter 13 in the form of a WSe₂ monolayer was placed on the aforementioned light emitting region with the use of a micromanipulator. After applying the monolayer 13, the instrument was fastened in a TO5.6 type semiconductor package. Because the upper surface of the layer 9 is flat regardless of the LED light emitting region size, it is possible to place the emitter 13 layer thereon accurately. Also, a tungsten disulfide (WS₂) monolayer or a molybdenum disulfide (MoS₂) monolayer can be used as an emitter 13 of a hybrid diode according to the invention. A LED, exciting the emitter 13, fabricated according to the aforementioned method, emits light only in the region which was not subjected to ion implantation (12). Fig.1 presents the current flow 14 from the lower 11 to the upper 10 contact by means of a dashed line. A high-conductive n-type layer (9) makes it possible to place an upper contact 10 outside the light emitting region with the diameter D. The limitation, by the aforementioned ion implantation 12, of the light emitting region in the LED, reduces the luminous power, and as a consequence essentially reduces the undesirable impact of photons, generated by said LED, with the energy comparable to photons from the emitter 13. This is very important due to be able to distinguish single photon emission from WSe₂.

Fig.4 presents an electroluminescence spectrum of said diode for the current density of 25A/cm² for eight different operating temperatures ranging from 10 K to 300 K. Individual spectra are shifted along the vertical axis in the diagram to separate them for the purpose of a better presentation of the results. As shown by said diagram, the amplitude of the electroluminescence exciting the emitter 13 does not decrease in line with the reduction of the operating temperature, which makes it possible to effectively excite the TMD layer. The diagram shown in Fig.5 presents a spectrum of excitation of a WSe₂ monolayer to emit photons by the aforementioned LED operating at the temperature of 10 K. This diagram shows a very narrow emission line in the wavelength of 715.7 nm. Fig.6 presents the correlation function (g₂) of photons at the temperature of 10 K emitted by the aforementioned hybrid diode according to the invention for the aforementioned wavelength of 715.7 nm. The minimum of the function is only 0.22, while in the known devices for single photon emission a minimum of 0.5 is acceptable. The behaviour of the g₂ correlation function was determined in the Hanbury Brown and Twiss interferometer, wherein detailed information about the methods of quality assessment of devices that emit single photons, a description of the g₂ correlation function used for this purpose, and a description of the interferometer used in this embodiment are disclosed in the publication by Y. Arakawa, and M. Holmes, titled "Progress in quantum-dot single photon sources for quantum information technologies: A broad spectrum overview", [Appl. Phys. Rev. 7, 021309 (2020)].

The aforementioned hybrid diode according to the invention can operate within atemperature range from 1 to 300 K, with the optimum temperature range of operation being from 1 to 150 K.

## Claims

1. A hybrid light emitting diode for emitting single photons, wherein it contains a photon emitter (13) in the form of a transition metal dichalcogenide (TMD) monolayer and a source of light exciting said emitter (13), in the form of an epitaxial layer structure of a light emitting diode made of group-III nitrides on a crystalline substrate (1) of gallium nitride, with said structure being composed of, counted from the crystalline substrate (1), a lower n-type conductivity layer (2), a tunnel junction (3), a hole injection layer (4), an active region (5, 6, 7), an electron injection layer (8), and an upper n-type conductivity layer (9), wherein the photon emitter (13) is placed on the upper surface of the upper n-type conductivity layer (9), in a light emitting region surrounded by a region (12) of an epitaxial structure that is made electrically inactive by the ion implantation method, extending vertically from the upper surface of the electron injection layer (8) to the inside of the lower n-type conductivity layer (2), the surface area of the light emitting region on the upper surface of the electron injection layer (8) ranges from 7 to 5000 µm² and can be inscribed into a circle with the diameter (D) of at least 3 µm, while the active region of the light emitting diode is composed, counted from the crystalline substrate (1), of a lower barrier layer (5), a quantum well layer (6) and an upper barrier layer (7), wherein the lower (5) and upper (7) barrier layers are made of an undoped InₓGa₁₋ₓN indium gallium nitride alloy, wherein the indium content *x* ranges from 0.01 to 0.08, while the quantum well layer (6) is made of an undoped In_{y}Ga_{1-y}N indium gallium nitride alloy, wherein the indium content y ranges from 0.1 to 0.2.

2. The hybrid diode according to claim 1, wherein the photon emitter (13) is composed of a tungsten diselenide (WSe₂) monolayer, of a tungsten disulfide (WS₂) monolayer or of a molybdenum disulfide (MoS₂) monolayer.

3. The hybrid diode according to claim 1 or 2, wherein the tunnel junction (3) is composed, counted from the crystalline substrate (1), of a first sublayer (3A), of a second sublayer (3B), of a third sublayer (3C) and of a fourth sublayer (3D), all made of doped In_{y}Ga_{1-y}N indium gallium nitride alloys, wherein the indium contents y in the first (3A) and in the fourth (3D) sublayer of the tunnel junction (3) are identical and range from 0.01 to 0.04 and said sublayers (3A, 3D) are doped with silicon (3A) and magnesium (3D), respectively, at the level from 2 × 10¹⁹ cm⁻³ to 5 × 10¹⁹ cm⁻³, the indium contents y in the second (3B) and in the third (3C) sublayer of said tunnel junction (3) are identical and range from 0.15 to 0.25, the second sublayer (3B) of the tunnel junction (3) is silicon- or germanium-doped with the doping level ranging from 50 × 10¹⁹ cm⁻³ to 100 × 10¹⁹ cm⁻³, while the third sublayer (3C) of the tunnel junction (3) is magnesium-doped with the doping level ranging from 10 × 10¹⁹ cm⁻³ to 50 × 10¹⁹ cm⁻³.

4. A method of fabrication of a hybrid light emitting diode emitting single photons, containing a photon emitter in the form of a transition metal dichalcogenide (TMD) monolayer and a light source exciting said photon emitter, wherein first an epitaxial layer structure of a light emitting diode, fulfilling the role of an exciting light source, is fabricated by applying layers of group-III nitrides on a crystalline substrate (1) made of gallium nitride in the process of nitrogen plasma assisted molecular beam epitaxy (PAMBE) growth, wherein a lower n-type conductivity layer (2), a tunnel junction (3), a hole injection layer (4), an active region (5, 6, 7) and an electron injection layer (8) are applied successively on the aforementioned substrate (1), subsequently, the layer structure growth process is interrupted and the light emitting field on the upper surface of the electron injection layer (8) is limited by surrounding the original light emitting field with an epitaxial structure region (12) that is made electrically inactive by the ion implantation method and extends vertically from the upper surface of the electron injection layer (8) to the inside of the lower n-type conductivity layer (2), such that the surface area of the limited light emission field ranges from 7 to 5000 µm² and can be inscribed into a circle with the diameter (D) of at least 3 µm, after the limitation of the light emitting field the growth of the epitaxial structure is ended by applying an upper n-type conductivity layer (9), and subsequently a photon emitter (13) is placed on the upper surface of the fabricated upper n-type conductivity layer (9), in the previously limited light emitting field, while during the fabrication of the active region of a light emitting diode, a lower barrier layer (5), a quantum well layer (6) and an upper barrier layer (7) are applied successively, counted from the crystalline substrate (1), wherein the lower (5) and upper (7) barrier layers are made of an undoped InₓGa₁₋ₓN indium gallium nitride alloy, wherein the indium content *x* ranges from 0.01 to 0.08, while the quantum well layer (6) is made of an undoped In_{y}Ga_{1-y}N indium gallium nitride alloy, wherein the indium content y ranges from 0.1 to 0.2.

5. The method according to claim 4, wherein a tungsten diselenide (WSe₂) monolayer, a tungsten disulfide (WS₂) monolayer or a molybdenum disulfide (MoS₂) monolayer is used as the photon emitter (13).

6. The method according to claim 4 or 5, wherein the application of the tunnel junction (3) consists in applying successively, counted from the crystalline substrate (1), a first sublayer (3A), a second sublayer (3B), a third sublayer (3C) and a fourth sublayer (3D), which are made of doped In_{y}Ga_{1-y}N indium gallium nitride alloys, wherein the indium contents y in the first (3A) and in the fourth (3D) sublayer of the tunnel junction (3) are identical and range from 0.01 to 0.04 and said sublayers (3A, 3D) are doped with silicon (3A) and magnesium (3D), respectively, at the level from 2 × 10¹⁹ cm⁻³ to 5 × 10¹⁹ cm⁻³, the indium contents y in the second (3B) and in the third (3C) sublayer of said tunnel junction (3) are identical and range from 0.15 to 0.25, the second sublayer (3B) of the tunnel junction (3) is doped with silicon or germanium with the doping level ranging from 50 × 10¹⁹ cm⁻³ to 100 × 10¹⁹ cm⁻³, while the third sublayer (3C) of the tunnel junction (3) is doped with magnesium with the doping level ranging from 10 × 10¹⁹ cm⁻³ to 50 × 10¹⁹ cm⁻³.

## Patentansprüche

1. Eine hybride Leuchtdiode zur Emission von Einzelphotonen, **dadurch gekennzeichnet, dass** sie einen Photonenemitter (13) in Form einer ÜbergangsmetallDichalcogenid (TMD)-Monoschicht und eine den Emitter (13) anregende Lichtquelle in Form einer epitaktischen Schichtstruktur einer Leuchtdiode aus Nitriden der Gruppe II auf einem kristallinen Substrat (1) aus Galliumnitrid enthält, wobei die Struktur, ausgehend von dem kristallinen Substrat (1), aus einer unteren n-Typ-Leitfähigkeitsschicht (2), einem Tunnelübergang (3), einer Lochinjektionsschicht (4), einem aktiven Bereich (5, 6, 7), einer Elektroneninjektionsschicht (8) und einer oberen n-Typ-Leitfähigkeitsschicht (9) besteht, wobei der Photonenemitter (13) auf der oberen Fläche der oberen n-Typ-Leitfähigkeitsschicht (9) angeordnet ist, in einem lichtemittierenden Bereich, der von einem Bereich (12) einer epitaktischen Struktur umgeben ist, die durch das Ionenimplantationsverfahren elektrisch inaktiv gemacht wurde, und der sich vertikal von der oberen Oberfläche der Elektroneninjektionsschicht (8) zur Innenseite der unteren n-Typ-Leitfähigkeitsschicht (2) erstreckt, die Oberfläche des lichtemittierenden Bereichs auf der oberen Oberfläche der Elektroneninjektionsschicht (8) liegt im Bereich von 7 bis 5000 µm2 und kann in einen Kreis mit dem Durchmesser (D) von mindestens 3 µm eingeschrieben werden, während der aktive Bereich der Leuchtdiode, von einem kristallinen Substrat (1) ausgehend, aus einer unteren Barriereschicht (5), einer Quantentopfschicht (6) und einer oberen Barriereschicht (7) besteht, wobei die untere (5) und die obere (7) Barriereschicht aus einer undotierten InₓGa₁-ₓN-Indium-GalliumNitrid-Legierung hergestellt sind, wobei der Indiumgehalt *x* im Bereich von 0,01 bis 0,08 liegt, während die Quantentopfschicht (6) aus einer undotierten In_{y}Ga₁-_{y}N-Indium-Gallium-Nitrid-Legierung besteht, wobei der Indiumgehalt y zwischen 0,1 und 0,2 liegt.

2. Die Hybriddiode nach Anspruch 1, wobei der Photonenemitter (13) aus einer Wolframdiselenid (WSe₂)-Monoschicht, aus einer Wolframdisulfid (WS₂)-Monoschicht oder aus einer Molybdändisulfid (M0S₂)-Monoschicht aufgebaut ist.

3. Die Hybriddiode nach Anspruch 1 oder 2, wobei der Tunnelübergang (3) ausgehend von dem kristallinen Substrat (1) aus einer ersten Teilschicht (3A), einer zweiten Teilschicht (3B), einer dritten Teilschicht (3C) und einer vierten Teilschicht (3D) zusammengesetzt ist, die alle aus dotierten In_{y}Ga₁-_{y}N-Indium-Gallium-Nitrid-Legierungen bestehen, wobei die Indiumgehalte y in der ersten (3A) und in der vierten (3D) Teilschicht des Tunnelübergangs (3) identisch sind und zwischen 0,01 und 0,04 liegen und die Teilschichten (3A, 3D) mit Silizium (3A) bzw. Magnesium (3D) auf einem Niveau von 2 × 10¹⁹cm⁻³ to 5 × 10¹⁹ cm⁻³ dotiert sind, die Indiumgehalte y in der zweiten (3B) und in der dritten (3C) Teilschicht des Tunnelübergangs (3) identisch sind und zwischen 0,15 und 0,25 liegen, die zweite Teilschicht (3B) des Tunnelübergangs (3) ist mit Silizium oder Germanium dotiert, wobei das Dotierungsniveau zwischen 50 × 10¹⁹ cm⁻³ und 100 × 10¹⁹ cm⁻³ liegt, während die dritte Teilschicht (3C) des Tunnelübergangs (3) mit Magnesium dotiert ist, wobei das Dotierungsniveau zwischen 10×10¹⁹ cm⁻³ und 50 × 10¹⁹ cm⁻³ liegt.

4. Ein Verfahren zur Herstellung einer hybriden lichtemittierenden Diode, die einzelne Photonen emittiert, enthaltend einen Photonenemitter in Form einer Übergangsmetalldichalcogenid (TMD)-Monoschicht und eine Lichtquelle, die den Photonenemitter anregt, wobei
zunächst eine epitaktische Schichtstruktur einer lichtemittierenden Diode, die die Rolle einer anregenden Lichtquelle erfüllt, durch Aufbringen von Schichten aus Nitriden der Gruppe II auf ein kristallines Substrat (1) aus Galliumnitrid im Verfahren der Stickstoff-Plasma-unterstützten Molekularstrahlepitaxie (PAMBE) hergestellt wird, wobei eine untere n-Typ-Leitfähigkeitsschicht (2), ein Tunnelübergang (3), eine Lochinjektionsschicht (4), ein aktiver Bereich (5, 6, 7) und eine Elektroneninjektionsschicht (8) nacheinander auf das vorgenannte Substrat (1) aufgebracht werden, anschließend der Schichtstruktur-Wachstumsprozess unterbrochen wird und das lichtemittierende Feld auf der oberen Oberfläche der Elektroneninjektionsschicht (8) begrenzt wird, indem das ursprüngliche lichtemittierende Feld mit einem epitaktischen Strukturbereich (12) umgeben wird, der durch das Ionenimplantationsverfahren elektrisch inaktiv gemacht wird und sich vertikal von der oberen Oberfläche der Elektroneninjektionsschicht (8) zur Innenseite der unteren n-Typ-Leitfähigkeitsschicht (2) erstreckt, so dass die Oberfläche des begrenzten Lichtemissionsfeldes im Bereich von 7 bis 5000 µm² liegt und in einen Kreis mit einem Durchmesser (D) von mindestens 3 µm eingeschrieben werden kann, nach der Begrenzung des Lichtemissionsfeldes wird das Wachstum der epitaktischen Struktur durch Aufbringen einer oberen n-Typ-Leitfähigkeitsschicht (9) beendet, und anschließend wird ein Photonenemitter (13) auf der oberen Oberfläche der hergestellten oberen n-Typ-Leitfähigkeitsschicht (9) angeordnet, in dem zuvor begrenzten lichtemittierenden Feld angeordnet wird, während im Laufe der Herstellung des aktiven Bereichs einer lichtemittierenden Diode nacheinander eine untere Barriereschicht (5), eine Quantentopfschicht (6) und eine obere Barriereschicht (7), ausgehend von dem kristallinen Substrat (1), aufgebracht werden, wobei die untere (5) und die obere (7) Barriereschicht aus einer undotierten InₓGa₁-ₓN-Indium-Gallium-Nitrid-Legierung hergestellt sind, wobei der Indiumgehalt *x* im Bereich von 0,01 bis 0,08 liegt, während die Quantentopfschicht (6) aus einer undotierten In_{y}Ga₁-_{y}N-Indium-Gallium-Nitrid-Legierung hergestellt ist, wobei der Indiumgehalt y im Bereich von 0,1 bis 0,2 liegt.

5. Das Verfahren nach Anspruch 4, wobei eine Wolframdiselenid (WSe₂)-Monoschicht, eine Wolframdisulfid (WS₂)-Monoschicht oder eine Molybdändisulfid (M0S₂)-Monoschicht als Photonenemitter (13) verwendet wird.

6. Das Verfahren nach Anspruch 4 oder 5, wobei das Aufbringen des Tunnelübergangs (3) darin besteht, ausgehend von dem kristallinen Substrat (1) nacheinander eine erste Teilschicht (3A), eine zweite Teilschicht (3B), eine dritte Teilschicht (3C) und eine vierte Teilschicht (3D) aufzubringen, die aus dotierten In_{y}Ga₁-_{y}N-Indium-Gallium-Nitrid-Legierungen bestehen, **dadurch gekennzeichnet, dass** der Indiumgehalt y in der ersten (3A) und in der vierten (3D) Teilschicht des Tunnelübergangs (3) identisch ist und zwischen 0,01 bis 0,04 liegt und die Teilschichten (3A, 3D) mit Silizium (3A) bzw. Magnesium (3D) auf einem Niveau von 2×10¹⁹ cm⁻³ bis 5×10¹⁹cm⁻³ dotiert sind, die Indiumgehalte y in der zweiten (3B) und in der dritten (3C) Teilschicht des Tunnelübergangs (3) identisch sind und zwischen 0,15 und 0,25 liegen, die zweite Teilschicht (3B) des Tunnelübergangs (3) ist mit Silizium oder Germanium dotiert, wobei der Dotierungsgrad zwischen 50 × 10¹⁹ cm⁻³ und 100× 10¹⁹ cm⁻³ liegt, während die dritte Teilschicht (3C) des Tunnelübergangs (3) mit Magnesium dotiert ist, wobei der Dotierungsgrad zwischen 10 × 10¹⁹ cm⁻³ und 50 × 10¹⁹ cm⁻³ liegt.

## Revendications

1. Une diode électroluminescente hybride destinée à émettre des photons uniques, dans laquelle elle contient un émetteur de photons (13) sous la forme d'une monocouche de dichalcogénure de métal de transition (TMD) et une source de lumière excitant ledit émetteur (13), sous la forme d'une structure de couche épitaxiale d'une diode électroluminescente constituée de nitrures de groupe III sur un substrat cristallin (1) de nitrure de gallium, cette structure étant composée, à partir du substrat cristallin (1), d'une couche de conductivité de type n inférieure (2), d'une jonction tunnel (3), d'une couche d'injection de trous (4), d'une région active (5, 6, 7), d'une couche d'injection d'électrons (8) et d'une couche de conductivité de type n supérieure (9), dans laquelle l'émetteur de photons (13) est placé sur la surface supérieure de la couche conductrice de type n supérieure (9), dans une région électroluminescente entourée d'une région (12) d'une structure épitaxiale rendue électriquement inactive par la méthode d'implantation ionique, s'étendant verticalement de la surface supérieure de la couche d'injection d'électrons (8) jusqu'à l'intérieur de la couche conductrice de type n inférieure (2), la surface de la région électroluminescente sur la surface supérieure de la couche d'injection d'électrons (8) est comprise entre 7 et 5000 µm2 et peut être inscrite dans un cercle dont le diamètre (D) est d'au moins 3 µm, tandis que la région active de la diode électroluminescente est composée, à partir du substrat cristallin (1), d'une couche barrière inférieure (5), d'une couche à puits quantique (6) et d'une couche barrière supérieure (7), dans laquelle les couches barrières inférieure (5) et supérieure (7) sont constituées d'un alliage de nitrure de gallium-indium InₓGa₁₋ₓN non dopé, dans laquelle la teneur en indium x est comprise entre 0,01 et 0,08, tandis que la couche à puits quantique (6) est constituée d'un alliage de nitrure de gallium-indium In_{y}Ga_{1-y}N non dopé, dans laquelle la teneur en indium y est comprise entre 0,1 et 0,2.

2. La diode hybride selon la revendication 1, dans laquelle l'émetteur de photons (13) est composé d'une monocouche de diséléniure de tungstène (WSe₂), d'une monocouche de disulfure de tungstène (WS₂) ou d'une monocouche de disulfure de molybdène (MoS₂).

3. La diode hybride selon la revendication 1 ou 2, dans laquelle la jonction tunnel (3) est composée, à partir du substrat cristallin (1), d'une première sous-couche (3A), d'une deuxième sous-couche (3B), d'une troisième sous-couche (3C) et d'une quatrième sous-couche (3D), toutes constituées d'alliages de nitrure gallium-indium In_{y}Ga_{1-y}N dopés, dans laquelle les teneurs en indium y dans la première (3A) et dans la quatrième (3D) sous-couche de la jonction tunnel (3) sont identiques et comprises entre 0,01 et 0,04 et lesdites sous-couches (3A, 3D) sont dopées au silicium (3A) et au magnésium (3D), respectivement, à un niveau compris entre 2 × 10¹⁹cm⁻³ et 5 × 10¹⁹ cm⁻³, les teneurs en indium y dans la deuxième (3B) et dans la troisième (3C) sous-couche de ladite jonction tunnel (3) sont identiques et comprises entre 0.15 à 0,25, la deuxième sous-couche (3B) de la jonction tunnel (3) est dopée au silicium ou au germanium avec un niveau de dopage allant de 50 × 10¹⁹ cm⁻³ à 100 × 10¹⁹ cm⁻³, tandis que la troisième sous-couche (3C) de la jonction tunnel (3) est dopée au magnésium avec un niveau de dopage allant de 10×10¹⁹ cm⁻³ à 50 × 10¹⁹ cm⁻³.

4. Un procédé de fabrication d'une diode électroluminescente hybride émettant des photons uniques, contenant un émetteur de photons sous la forme d'une monocouche de dichalcogénure de métal de transition (TMD) et une source de lumière excitant ledit émetteur de photons, dans lequel
tout d'abord, une structure de couche épitaxiale d'une diode électroluminescente, jouant le rôle d'une source de lumière excitante, est fabriquée en appliquant des couches de nitrures de groupe sur un substrat cristallin (1) en nitrure de gallium dans le processus de croissance par épitaxie par jets moléculaires assistée par plasma d'azote (PAMBE), dans lequel une couche de conductivité de type n inférieure (2), une jonction tunnel (3), une couche d'injection de trous (4), une région active (5, 6, 7) et une couche d'injection d'électrons (8) sont appliquées successivement sur le substrat susmentionné (1), ensuite, le processus de croissance de la structure de couche est interrompu et le champ électroluminescent sur la surface supérieure de la couche d'injection d'électrons (8) est limité en entourant le champ électroluminescent original d'une région de structure épitaxiale (12) qui est rendue électriquement inactive par le procédé d'implantation ionique et qui s'étend verticalement de la surface supérieure de la couche d'injection d'électrons (8) vers l'intérieur de la couche de conductivité de type n inférieure (2), de telle sorte que la surface du champ électroluminescent limité soit comprise entre 7 et 5000 µm² et puisse être inscrite dans un cercle dont le diamètre (D) est d'au moins 3 µm, après la limitation du champ électroluminescent, la croissance de la structure épitaxiale est terminée par l'application d'une couche de conductivité de type n supérieure (9), puis un émetteur de photons (13) est placé sur la surface supérieure de la couche de conductivité de type n supérieure fabriquée (9), dans le champ électroluminescent précédemment limité, tandis que pendant la fabrication de la région active d'une diode électroluminescente, une couche barrière inférieure (5), une couche à puits quantique (6) et une couche barrière supérieure (7) sont appliquées successivement, à partir du substrat cristallin (1), dans lequel les couches barrières inférieure (5) et supérieure (7) sont constituées d'un alliage de nitrure de gallium-indium InₓGa₁-ₓN non dopé, dans lequel la teneur en indium x est comprise entre 0,01 et 0,08, tandis que la couche à puits quantique (6) est constituée d'un alliage de nitrure de gallium-indium In_{y}Ga₁-_{y}N non dopé, dans laquelle la teneur en indium y est comprise entre 0,1 et 0,2.

5. Le procédé selon la revendication 4, dans lequel une monocouche de diséléniure de tungstène (WSe₂), une monocouche de disulfure de tungstène (WS₂) ou une monocouche de disulfure de molybdène (MoS₂) est utilisée comme émetteur de photons (13).

6. Le procédé selon la revendication 4 ou 5, dans lequel l'application de la jonction tunnel (3) consiste à appliquer successivement, à partir du substrat cristallin (1), une première sous-couche (3A), une deuxième sous-couche (3B), une troisième sous-couche (3C) et une quatrième sous-couche (3D), qui sont constituées d'alliages de nitrure gallium-indium In_{y}Ga₁-_{y}N dopés, dans lequel les teneurs en indium y dans la première (3A) et dans la quatrième (3D) sous-couche de la jonction tunnel (3) sont identiques et comprises entre 0,01 et 0,04 et lesdites sous-couches (3A, 3D) sont dopées au silicium (3A) et au magnésium (3D), respectivement, à un niveau compris entre 2×10¹⁹ cm⁻³ et 5×10¹⁹cm⁻³, les teneurs en indium y dans la deuxième (3B) et dans la troisième (3C) sous-couche de ladite jonction tunnel (3) sont identiques et comprises entre 0,15 et 0,25, la deuxième sous-couche (3B) de la jonction tunnel (3) est dopée au silicium ou au germanium avec un niveau de dopage compris entre 50 × 10¹⁹ cm⁻³ et 100x 10¹⁹ cm⁻³, tandis que la troisième sous-couche (3C) de la jonction tunnel (3) est dopée au magnésium avec un niveau de dopage compris entre 10 × 10¹⁹ cm⁻³ et 50 × 10¹⁹ cm⁻³.
